Europäisches Patentamt

European Patent Office

Office européen des brevets

(11) Veröffentlichungsnummer: **0 461 544 A1**

## (12) EUROPÄISCHE PATENTANMELDUNG

(21) Anmeldenummer: **91109224.5**

(51) Int. Cl.⁵: **H01L 23/427**

(22) Anmeldetag: **06.06.91**

(30) Priorität: **15.06.90 DE 4019091**

(43) Veröffentlichungstag der Anmeldung:
**18.12.91 Patentblatt 91/51**

(84) Benannte Vertragsstaaten:
**AT BE CH DE DK ES FR GB GR IT LI LU NL SE**

(71) Anmelder: **Battelle-Institut e.V.**
**Am Römerhof 35 Postfach 900 160**
**W-6000 Frankfurt/Main 90(DE)**

(72) Erfinder: **Tschulena, Guido, Dr.**
**Reichenberger Strasse 5**
**W-6393 Wehrheim(DE)**

(54) **Wärmeableitungseinrichtung und Verfahren zu deren Herstellung.**

(57) Wärmeableitungseinrichtungen für elektronische Baulelemente werden in Form von Kanälen vorgesehen, die entweder in die Unterseite des Halbleiterchips (1) integriert sind oder in einem zusätzlichen, dünnen und größer als der Bauelementchip dimensionierten Chip (12) ausgebildet sind, der zwischen der Bauelementchipunterseite und dem Chipsockel(4) angeordnet wird. Die Kanäle (13) werden mit einem Material, (14) vorzugsweise mit Schmelzmaterial, gefüllt, das bei für die Halbleiterfunktion kritischen Temperaturen einem Wärme absorbierenden Phasenübergang unterliegt. Auf diese Weise können insbesondere kurzzeitige Wärmespitzen zuverlässig abgeführt werden. Die Kanäle werden mittels mikromechanischer Ätztechnik ausgebildet und vorzugsweise mittels eines Spin-Coatingverfahrens gefüllt.

Fig. 3

EP 0 461 544 A1

Die Erfindung betrifft Wärmeableitungseinrichtungen, insbesondere für elektronische Halbleiterbauelemente sowie Verfahren zur Herstellung dieser Einrichtungen und geht dabei von Einrichtungen bzw. Verfahren aus, wie sie im Oberbegriff des Patentanspruchs 1 bzw. 6 gewürdigt sind.

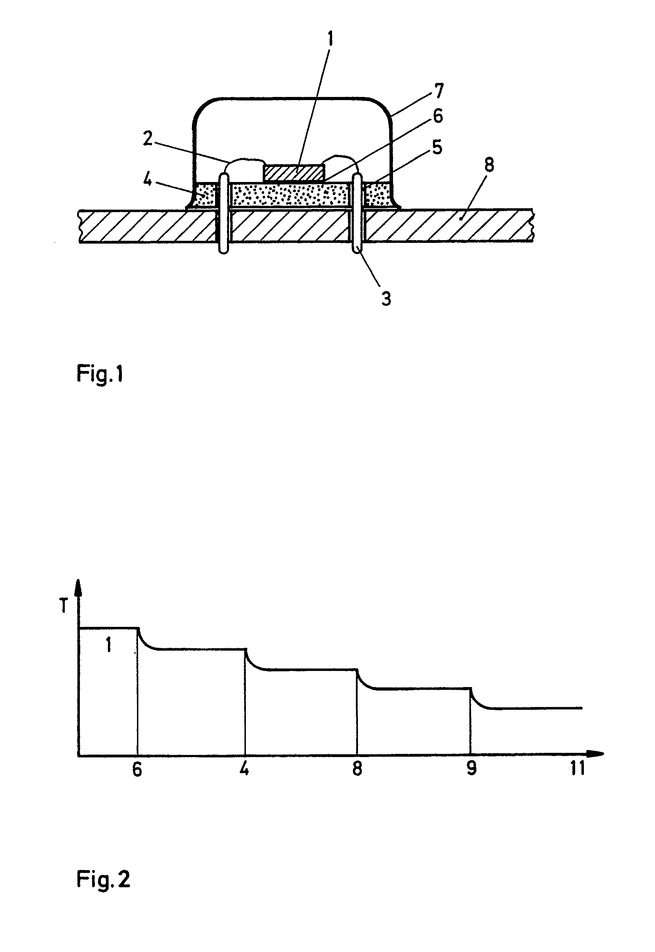

Zahlreiche übliche elektronische Halbleiterbauelemente, z.B. einfache Bauelemente wie integrierte Schaltungen oder auch gegebenenfalls Siliziumsensoren, sind beispielsweise wie in FIG.1 in Form eines Halbleiterchips 1 über eine Klebe- oder Lötstelle 6 auf einem Gehäusesockel oder -boden 4 aufgebracht. Einerseits soll der Chip durch das Gehäuse bzw. dessen Sockel vor Umwelteinflüssen geschützt werden. Andererseits soll der Gehäusesockel über darin vorgesehene Kontaktstifte 3 und auf diese gebondete Drähte 2 einen lösbaren Kontakt des Bauelements zu einem Sockel bzw. einer Leiterplatte 8 ermöglichen. Darüberhinaus muß die im Chip erzeugte Verlustleistungswärme über den Gehäuseboden 4 und über die Anschlußstifte 3 in die Leiterplatte 8 und auf Wärmeableitkörper 9 übertragen werden. Für die Ermittlung der Temperaturverteilung zwischen Chip und Gehäuse stellt man Wärmebilanzbetrachtungen an.

Die im Siliziumchip erzeugte Wärme wird im wesentlichen mittels Wärmeleitung (hauptsächlich Wärmediffusion) vom Chip zum Gehäuse transportiert. Dort breitet sich die Wärme auf dem Gehäuseboden 4 aus und erwärmt diesen etwas. Diese Wärme wird einerseits über Wärmeleitung vom Gehäuseboden 4 zur Gehäuseabdeckung 7 und andererseits über Konvektion in Luft abgeführt. Ferner erfolgt die Wärmeabfuhr insbesondere über die Anschlußstifte 3 vom Gehäuseboden in die darunterliegende Leiterplatte 8 oder Hybridelektronikkeramik. Diese Betrachtungen gelten für Standardgehäuse wie z.B. T05- und SOT- Gehäuse sowie auch gleichermaßen für Spezialgehäuse.

Bei SMD-Gehäusen erfolgt die Wärmeableitung der wärmeerzeugenden Chips analog in die Kapselung und auf die Beinchen. Dabei sind die Siliziumchips üblicherweise auf Sockeln aufgeklebt. Die elektrischen Kontakte werden von den Siliziumchips auf die Metallstifte gebondet.

Die abzuführende Wärmeleistung ensteht im allgemeinen in den in die Oberfläche der Silizium-Halbleiterchips integrierten Schaltkreisen. Die erzeugte Verlustleistungswärme muß von dort zunächst eine Strecke von im allgemeinen zwischen 100 $\mu$m und 600 $\mu$m durch das Silizium geleitet werden. Dabei tritt eine gewisse Verbreiterung der Wärmefront auf. Über den Kleber bzw. das Lötmittel wird die Wärme nun weiter in den Metallsockel des Gehäuses geleitet. Dabei ist ein Warmeübergangswiderstand des Klebers von etwa 0,42 W/K zu beobachten. Mit den üblichen Befestigungstechniken können nur begrenzte Wärmeleistungen aus dem Siliziumchip abgeführt werden, denn die Temperatur der Oberfläche des Chips stellt sich als Gleichgewicht zwischen der erzeugten Wärmeleistung und der abgeführten Wärmeleistung ein. In FIG.2 ist der sich ergebende Temperaturverlauf für die verschiedenen Bereiche bzw. Übergangsstellen der Halbleiteranordnung skizziert. Die Temperatur der Chipoberfläche, die bei Silizium zwischen maximal 125 C und 150 C liegen darf, ist mit 1 angedeutet. Darauf folgen die Klebe- oder Lötstelle 6, der Gehäuseboden 4, die sich durch Kontaktwärmeleitung auszeichnende Metall/Glasverbin-dung 10 zwischen Gehäuseboden 4 und Leiterplatte bzw. Sockel 8, der Wärmeableitkörper 9 z.B. in Form eines Kühlblechs und die Umgebung 11, die sich auf Raumtemperatur befindet.

Der skizzierte Temperaturverlauf ist das Ergebnis eines Wärmeaustauschs, der sich gemäß dem obigen Gleichgewicht einstellt. Durch den Wärmeaustausch muß sichergestellt sein, daß die maximal zulässige Temperatur des Siliziums zwischen 125 C und 150 C nicht überschritten wird. Denn bei höheren Temperaturen wird Silizium eigenleitend und die Funktion der elektronischen Bauelemente kann nicht mehr aufrechterhalten werden. Ferner ist zu beachten, daß bereits bei Temperaturen zwischen 100 C und 125 C sich die Sperrspannungen der Dioden und Transistoren sowie andere Parameter verschlechtern. Es hat sich gezeigt, daß mit Luftkühlung bei Chips Verlustleistungen von maximal einigen Watt abgeführt werden können. Auch bei forcierter Luftkühlung können bis zu etwa 5 Watt abgeführt werden. Dies ist auch der Fall, wenn statt einer Klebeverbindung sogenannte eutektische Diebonds mit einem resultierenden Wärmeübergangswiderstand von 0,33 W/K verwendet werden.

Es sind bisher eine Reihe passiver Kühlmaßnahmen vorgeschlagen worden, die versuchen, allein durch Wärmeleitung mit Hilfe von Kühlkörpern eine ausreichende Kühlung im Betrieb des Halbleiters zu erzielen. So beschreibt die DE 37 35 818 A1 eine passive Kühleinrichtung in Form eines Si-Hilfschips oder -substrats, der gleichzeitig als Kühlkörper und Schutzwiderstand für ein auf seiner Oberseite angebrachtes Leuchtelement in Chipform dient und mit seiner Rückseite auf einem größeren konventionellen Kühlkörper befestigt ist, der wiederum an einer Rahmenstruktur angebracht ist. Jedoch bieten derartige Maßnahmen keine ausreichende Lösung für die geschilderte Problematik.

Um die Wärmeableitung zu verbessern, wird ferner z.B. eine Kühlung des Substrats bzw. der Leiterplatte vorgenommen. Jedoch stellt dies keine unmittelbare Kühlung des Chips ohne Wärmeübergangswiderstände dar und ist nur in Verbindung mit gut wärmeleitenden Zwischenschichten wirksam. Auch verhindert die große Wärmekapazität solcher Systeme, daß insbesondere schnell hintereinander auftretende kurze Wärmeimpulse ohne integrierende Aufheizung des Kühlsystems abgeleitet werden können. Die Möglichkeit einer direkteren und damit auch schnelleren Wärmeabfuhr ist in dem Buch "Mikromechanik" von A.Heuberger, Springer-Verlag, 1989, Seiten 480 bis 483 in dem Kapitel "Verbesserung der Wärmeableitung durch mikrostrukturiertes Silizium" beschrieben. Dort wird vorgeschlagen, in Silizium Gräben einzuarbeiten, die zur Erhöhung der Wärmeleitung mit Metallen wie Gold, Kupfer oder Silber gefüllt werden. Zu diesen mit Metallkügelchen gefüllten Gräben wird über Metallanschlußstifte im Chip ein Wärmeübergang hergestellt.

Eine noch effektivere Kühlung ergibt sich, wenn in der Siliziumchipunterseite Kanäle ausgebildet werden, durch die aktiv eine Kühlflüssigkeit, z.B. Wasser, geleitet wird. Die hierzu notwendigen relativ tiefen Gräben oder Kanäle können entweder durch Sägen oder auch durch ein im Kapitel 3.2.1 "Anisotrope Ätzverfahren" des oben erwähnten Buchs auf den Seiten 128 bis 140 erläuterte spezielle kristallorientierungsabhängige Ätztechnik ausgebildet werden, die eine naßchemische Tiefenätztechnik für mikromechanische Bauelemente mit verschiedenen möglichen Ätzlösungen darstellt. Gräben mit einer Tiefe und Breite im Bereich von 0,1 $\mu$m bis zu einigen 10 um sind damit ohne weiteres erzielbar.

Die beschriebene Flüssigkeitskühlung bewirkt eine sehr gute Wärmeableitung, abhängig von der Pumpgeschwindigkeit bis hin zu einer Wärmeableitleistung von theoretisch über 1000 Watt für einen Chip. Insbesondere kurzzeitige Wärmeimpulse können jedoch nur dann auch ausreichend schnell abgeführt werden, wenn die Strömungsgeschwindigkeiten entsprechend hoch sind.

Ferner ist aus IBM Technical Disclosure Bulletin, 1983, Band 25, Nr.8, Seiten 4118 bis 4119, eine Einrichtung entnehmbar, in der Kanäle durch anisotrope Ätztechnik in der Oberseite eines Kühlchips ausgebildet sind, der auf die Rückseite eines kleineren Halbleiterchips gebondet ist. Diese Anordnung befindet sich in einer sogenannten Heat-Pipe-Struktur, die gewährleistet, daß die infolge Wärmeentwicklung des Halbleiterchips verdampfte Flüssigkeit zum kühleren Ende der Heat-Pipe-Struktur transportiert wird, wo der Dampf kondensiert. Das über einer Wärmesenke abgekühlte Kondensat wird mittels Kapillarwirkung zurück in die Kanäle transportiert. Die Kanäle im Kühlchip sollen dessen Oberfläche vergrößern und dienen einem verbesserten Wärmeübergang.

Die Nachteile dieser geschlossenen, im wesentlichen auf einem Transportmechanismus von Gasen, bzw. Flüssigkeiten zur Wärmeabfuhr beruhenden Einrichtung, sind augenfällig. Die ganze Anordnung ist im Vergleich zum eigentlichen Halbleiterchip sehr groß und funktioniert nur, wenn die wiederholte oder kontinuierliche Auffüllung der Kanäle durch die Kapillarwirkung langfristig gewährleistet werden kann. Auch ist die Dampfatmosphäre in der Umgebung einer elektronischen Einheit alles andere als ideal.

Die EP 0 251 836 A1 zeigt prinzipiell eine ähnliche Heat-Pipe-Struktur, wobei die mit der Verdampfungsflüssigkeit teilweise gefüllten Kanäle entweder direkt im Chip ausgebildet sind oder in einer darauf geklebten Kappe in Form eines Chips aus gleichem Material. Wiederum sind eine Wärmesenke und eine Transporteinrichtung in Dochtform zur Wärmeableitung und zum Rücktransport des Kondensats vorgesehen. Die Wärmeableitung wird im wesentlichen durch den erläuterten Zirkulationsmechanismus des Dampftransports zum Kühlkörper und der Kondensatrückführung erzielt.

Gemäß der DE-AS 24 41 613 ist eine dielektrische Wärmeleitschicht aus $SiO_2$ mit einer oberen und unteren Deckschicht aus $Si_3N_4$ auf dem Halbleiterchip vorgesehen, in deren vom Halbleiterchip abgewandten Seite nach innen aufgeweitete Kanäle geätzt sind. Auch hier wird die Verdampfung einer in der Wärmeleitschicht aufgenommenen Flüssigkeit ausgenutzt und es sind Unterbrechungen in der Wärmeleitschicht zur ungehinderten Vedampfung vorgesehen. Zur Erzielung des nötigen Kondensatrücktransports ist wiederum eine Dochtstruktur innerhalb eines Gehäuses vorgesehen.

Der Erfindung liegt die Aufgabe zugrunde, eine Wärmeableitungseinrichtung sowie ein Verfahren zu deren Herstellung anzugeben, die eine weiterhin verbesserte Wärmeableitung zuverlässig insbesondere auch bei kurzzeitigen, impulsartigen Wärmeerzeugungen in den Schaltkreisen gestattet und dabei einfach und insbesondere kompakt herzustellen ist.

Diese Aufgabe wird durch den Gegenstand des Patentanspruchs 1 bzw. 6 gelöst.

Erfindungsgemäß ist in Kanälen, die entweder in die Unterseite des Elektronik-Halbleiterchips integriert sind oder in einen weiteren auf der Chipunterseite befestigten Wärmeableit-Halbleiterchip eingebracht sind, ein Schmelzmaterial aufgenommen, das über einer bestimmten Temperatur und damit vor allem auch bei entsprechenden kurzzeitigen Wärmeimpulsen vom Elektronik-Halbleiterchip einer endothermen Phasenumwandlung von fest nach flüssig unterliegt, wodurch der sofortige Abbau der kurzzeitigen Wärmespitze ermöglicht wird. Durch diese vergrößerte Wärmeableitung und durch die geringe Wärmekapazität dieser Einrichtungen kann zuverlässig verhindert werden, daß kurzzeitige Wärmeimpulse den Elektronik-Halbleiterchip auf Temperaturen in der Nähe oder über der maximal zulässigen Temperatur des Halbleitermaterials treiben.

Gegenüber den bekannten Heat-Pipe-Strukturen, die eine aktive Kühlung über die Flüssigkeitsverdampfung vorsehen, besteht der entscheidende Vorteil, daß die gesamte Einrichtung infolge des hier vermiedenen Wärmeaustauschs über einen Materialtransport sehr viel kompakter und haltbarer sowie als geschlossener Aufbau ausbildbar ist und lediglich das Einbringen der Schmelzmaterialien in die Kanäle ohne irgendeine zusätzliche Struktur erfordert.

Es sind zwar bereits in den Anfängen der Transistortechnik niedrig schmelzende Massen als Einbettmassen außerhalb des Transistorchips vorgeschlagen worden. Diese dienten jedoch allenfalls zur aktiven Wärmeableitung bei der Herstellung und nicht während des Betriebs des Transistors, wenn lediglich die passive Wärmeableitung über die erstarrten Einbettmassen ausgenutzt wurde.

So diente in DE-AS 1 041 600 ein metallisches Füllmaterial, in dem der Transistor und seine Anschlüsse über eine dünne Isolationsschicht in einem Gehäuse eingebettet waren, dazu, im Transistorbetrieb eine gute passive Wärmeableitung zum metallischen Gehäuse zu garantieren. Da das Füllmaterial selbst als Lötmittel zum Verschließen des Gehäuses benutzt und zur festen Einbettung des Transistors flüssig in das Gehäuse eingegossen wurde, wurden Materialien wie Zinn, Cadmium, Blei oder Wismuth bzw. Legierungen hiervon mit Schmelzpunkten kleiner 150 C und vorzugsweise kleiner 70 C verwendet.

Gemäß der DE-AS 1 042 132 wurde Paraffin als Füllmasse zwischen Chip und Gehäuse zur Einbettung eines Transistors vorgeschlagen, die ebenfalls in flüssiger Form in das Gehäuse eingefüllt wurde. Nach Erstarren des Paraffins wurde mit dem Verschließen des Gehäuses begonnen und hierbei ausgenutzt, daß bedingt durch die beim Schmelzen des Füllmaterials verbrauchte Wärme trotz der stetigen Wärmezufuhr beim Verschmelzen des Gehäuses die Temperatur erst dann über die Schmelztemperatur anstieg, wenn das gesamte Füllmaterial geschmolzen war. Dieser aktive Kühleffekt des Einbettmaterials wurde jedoch ausschließlich beim Verschließen des Gehäuses ausgenutzt.

Erfindungsgemäß hingegen werden die Schmelzmassen einerseits nicht zur Einbettung, sondern nur zur teilweisen Füllung der Kanäle der Wärmeableitvorrichtung verwendet und dienen andererseits insbesondere durch ihre wiederholt ausgenutzte Phasenumwandlung insbesondere bei plötzlich auftretenden Wärmespitzen zur aktiven Kühlung des Halbleiterbauelements in seinem Betrieb.

Besteht die erfindungsgemäße Wärmeableitungsvorrichtung aus einem gesonderten, dünnen Wärmeableitchip zwischen dem Elektronik-Chip und dem Gehäusesockel, so wird der Wärmeableitchip mit den darin eingeätzten tiefen Kanälen größer ausgebildet als der Elektronik-Chip. Somit erfolgt in der größer dimensionierten Wärmeableitstruktur eine Verbreiterung des Wärmeflusses auf den Sockel, wodurch eine bessere Wärmeableitung von der Siliziumoberfläche bis zum Gehäuseboden erfolgt. Dies stellt insbesondere eine Verbesserung für den Dauerbetrieb unter fortwährender Erwärmung der Elektronik-Chipoberfläche dar.

Darüberhinaus sind die Kanäle in den erfindungsgemäßen speziellen Wärmeableitkörpern mit dem Phasenumwandlungsmaterial in Form von Schmelzkörpern, teilweise (etwa bis drei Viertel) gefüllt. Diese Schmelzkörper oder Schmelzmassen sind so ausgewählt, daß sie im häufigsten Fall von Silizium-Elektronikchips bei Temperaturen zwischen 100 C und 150 C einen Phasenübergang aufweisen. Sobald an der Oberfläche des Standard-Siliziumchips erhöhte Temperaturen auftreten, beginnt in den Schmelzwärmekörpern eine Phasenumwandlung, sie schmelzen und absorbieren dadurch einen Großteil der Wärmeleistung.

Ein weiterer Vorteil der erfindungsgemäßen Wärmeableitchips besteht darin, daß diese nach Herstellung direkt auf den IC-Sockel auflötbar sind, so daß die Elektronik-Chiphersteller ohne Produktionsänderung ihre fertigen Elektronik-Chips durch Löten, anodisches Bonden usw. auf die Wärmeableitchips aufbringen können. Demgegenüber werden bei Integration der Kanäle in die Elektronik-Chipunterseite die Silizium-Wafer vor dem Zerteilen entsprechend vorbehandelt.

Ein weiterer Vorteil liegt darin, daß der mit Schmelzkörper gefüllte Wärmeableitchip eine etwa um einen Faktor 2 bis 6 größere Wärmeleitung und eine etwas höhere Wärmekapazität als der Siliziumchip allein aufweist. Auch dadurch wird die Wärmeableitung erhöht.

Bei Überschreitung der Phasenumwandlungstemperatur wird der Schmelzkörper flüssig. In diesem flüssigen Zustand liegt das Wärmeleitvermögen über dem des festen Zustands, wodurch die Wärmeableitkapazität weiter ansteigt.

Für beide Lösungen sind als Schmelzmassen insbesondere Metalle und Legierungen etwa auf Basis von Zinn, Zink, Wismut, Indium oder Blei geeignet. Es können jedoch auch andere Materialien wie Bienenwachs und Stearin eingesetzt werden, die eine Phasenumwandlung im oben angegebenen Bereich aufweisen, die ferner eine große Schmelzwärme aufweisen, die einer nicht zu großen thermischen Expansion zwischen dem festen und flüssigen Zustand unterliegen und die darüberhinaus mit den Materialien und Techniken des Siliziums kompatibel sind.

Die erfindungsgemäße Wärmeableitungseinrichtung eignet sich insbesondere für alle möglichen Bauelemente, die in Silizium oder mit der Siliziumtechnik kompatiblen Materialien wie z.B. Galliumarsenid ausgebildet werden. So kann die erfindungsgemäße Wirkung der vergrößerten Wärmeableitung oberhalb kritischer Temperaturen beispielsweise für integrierte Schaltungen, Thyristoren, Halbleiter-Laser und Sensoren, z.B. Magnetometer oder Bolometer eingesetzt werden.

Zur Herstellung der erforderlichen Kanäle wird vorzugsweise gemäß der speziellen Mikromechanikätztechnik vorgegangen, die im oben erwähnten Buch vorgeschlagen ist und die Ätzung ausreichend tiefer Kanäle zum Einbringen des Phasenumwandlungsmaterials gestatten. Die üblichen planaren Ätztechniken zur Bestückung der Chipoberfläche sind hierzu weniger gut geeignet.

Für das Einbringen der insbesondere Schmelzmassen, wird erfindungsgemäß ein speziell entwickeltes Hochtemperatur-Spin-Coating-Verfahren angewandt.

Im folgenden wird die Erfindung anhand der Zeichnungen näher erläutert. Es zeigen

FIG.1 einen Elektronik-Chip mit einer bekannten Wärmeableitungseinrichtung,

FIG.2 den Temperaturverlauf innerhalb der Anordnung aus FIG.1,

FIG.3 ein Ausführungsbeispiel für die erfindungsgemäße Wärmeableitungseinrichtung und

FIG.4 den schematisch skizzierten zeitlichen Verlauf von Wärmeimpulsen und dem entsprechend resultierenden Temperaturverlauf an der Chipoberfläche.

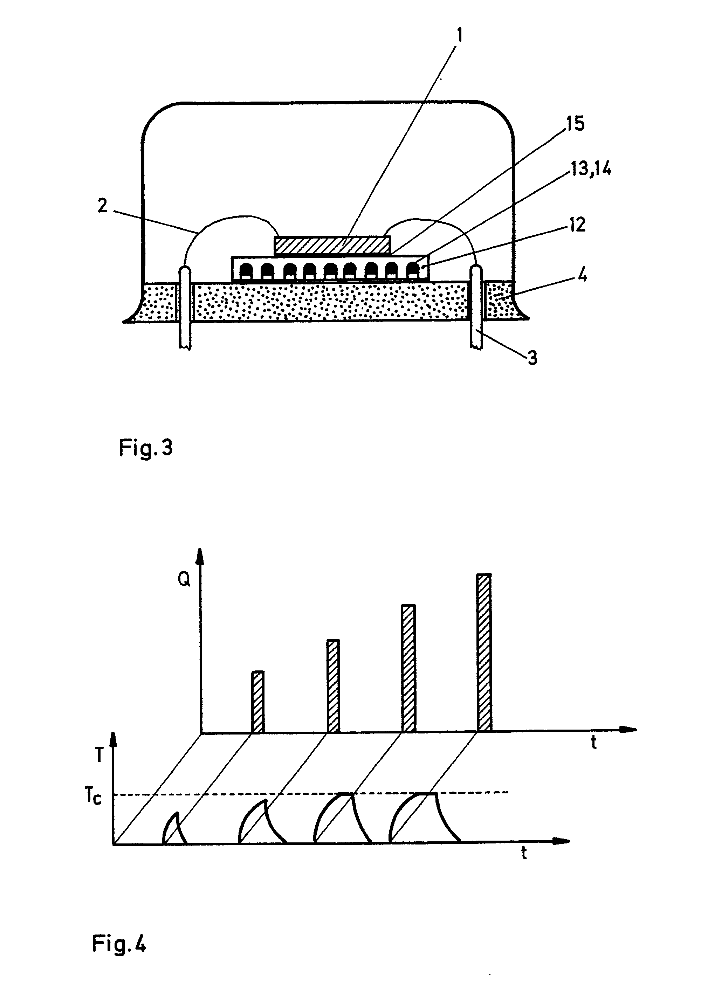

In Fig.3 ist wie beim Stand der Technik ein Siliziumchip 1 über Bonddrähte und durch einen Gehäuseboden geführte Kontaktstifte mit einer nicht dargestellten Leiterplatte verbunden. Zwischen der Chipunterseite und dem Gehäuseboden 4 befindet sich die erfindungsgemäße Wärmeableitungseinrichtung 12 in Form eines weiteren dünnen Siliziumchips. Dieser ist größer als der Elektronik-Chip 1 dimensioniert, um die weiter oben erläuterte verbesserte Wärmeableitung insbesondere auch im Langzeitbetrieb zu erzielen. Zwischen dem Chip 1 und dem Wärmeableitchip oder -körper 12 ist eine Glasschicht 15 für eine Verbindung durch anodisches Bonden vorgesehen. Im Wärmeableitkörper 12 sind Kanäle 13 ausgebildet, die etwa zur Hälfte mit Schmelzmassen oder -körpern 14 gefüllt sind.

Neben diesem Ausführungsbeispiel besteht die Möglichkeit, auf den Wärmeableitkörper zu verzichten und die Kanäle 13 direkt in die Unterseite des Chips 1 zu integrieren und ebenfalls vorzugsweise mit Schmelzmassen zu füllen.

Zunächst wird ein Verfahren zur Herstellung einer solchen in den Elektronik-Siliziumchip integrierten Wärmeableitungseinrichtung beschrieben. Hierbei wird von üblichen Siliziumbauelementen ausgegangen. Dabei sollen jedoch die Siliziumscheiben bzw. Wafer beidseitig poliert sein, um auch Fotolithographie- und Ätzverfahren auf der Waferrückseite ausführen zu können. Eine gewisse Justierung oder Ausrichtung der in die Rückseite zu ätzenden Kanäle bezüglich der Beschaffenheit der Chipvorderseite ist notwendig, jedoch sind hierbei an die Genauigkeit der Justierung keine großen Anforderungen zu stellen. Es reicht etwa eine Genauigkeit von etwa 5$\mu$m aus. Dabei ist lediglich auf die Orientierung der Kanäle relativ zur kristallographischen Orientierung des Siliziumwafers zu achten.

Standard für elektronische Halbleiterbauelemente ist die [100]-Orientierung des Siliziumwafers. In diesem Fall werden die Kanäle unter Verwendung des oben erwähnten Verfahrens zum orientierungsabhängigen Ätzen vorzugsweise parallel zur [100]-Richtung orientiert. Bei Anwendung dieses Verfahrens entstehen tiefe V-förmige Gräben mit [111]-Wänden. Die so gebildeten Kanäle werden mit den erfindungsgemäßen Schmelzmassen gefüllt.

In einer anderen Orientierung von Siliziumwafern, der [110]-Orientierung erlaubt das orientierungsabhängige Ätzen die Herstellung tiefer, rechteckiger Gräben mit senkrechten [111]-Wänden. Auch hier wrden die Kanäle mit den erfindungsgemäßen Schmelzmassen gefüllt.

Hierzu wird ein kürzlich entwickeltes, sogenanntes Hochtemperatur-Spin-Coatingverfahren angewandt, das bislang zur Beschichtung von Wafern bei Raumtemperatur benutzt wurde (siehe Deutsche Patentanmeldung P 40 19 090.0-45). Dabei wird der Wafer mit den darin ausgebildeten Kanälen auf einem heizbaren Drehteller durch Unterdruck vakuumfixiert. Die Siliziumscheibe bzw. der Wafer auf dem Drehteller wird auf Temperaturen knapp oberhalb des Schmelzpunktes der Schmelzflüssigkeit erhitzt. Aus einem ebenfalls geheizten, thermostatisierten Vorratsgefäß werden einige Tropfen der Schmelzflüssigkeit, z.B. Zinnlegierungen, auf den rotierenden Wafer aufgebracht. Es bildet sich in Abhängigkeit von der Umdrehungsgeschwindigkeit und der Viskosität der aufgebrachten Flüssigkeit eine wenige Mikrometer dicke Schicht. Durch die Oberflächenspannung zieht sich die Schmelzflüssigkeit gleichmäßig in die Kanäle zurück, wenn der Wafer abkühlt, und erstarrt dort.

Das erläuterte, entwickelte Verfahren mit der geheizten Spin-Coating-Apparatur läßt sich im übrigen auch allgemein gut zum Aufbringen von Metallschichten auf Wafern verwenden. Hierbei ergeben sich gegenüber herkömmlichen Verfahren, insbesondere bei Beschichtung strukturierter Oberflächen erhebliche Vorteile.

Auf diesen Verfahrensschritt folgend kann der Wafer in üblicher Weise in die einzelnen Chips zerteilt werden.

Der weitere Verfahrenschritt, in dem der einzelne Chip auf dem Sockel bzw. Gehäuseboden befestigt wird, sollte nicht bei zu hohen Temperaturen erfolgen. Es empfiehlt sich insbesondere eine Klebverbindung, da hiermit eine dicht und gut wärmeleitende Verbindung zum Sockel erzielbar ist.

Beim Verfahren zur Herstellung der erfindungsgemäßem Wärmeableitungseinrichtung in Form eines zusätzlichen Chips zwischen Gehäuseboden und Elektronik-Chipunterseite wird in ähnlicher Weise vorgegangen. In der polierten Unterseite eines Siliziumwafers werden gemäß den oben erläuterten Verfahrensschritten Kanäle ausgebildet und mit Schmelzmasse gefüllt. Daraufhin wird der Wafer in einzelne Chips zerteilt, die größer als die darüber anzubringenden Elektronik-Chips sind. Diese Wärmeableitchips werden anschließend direkt auf den IC Sockel bzw. die Gehäuseböden aufgelötet. Auf die so gebildeten Hochleistungswärmeableitsockel können dann vom IC Hersteller die jeweiligen Elektronik-Chips durch Löten, anodisches Bonden usw. aufgebracht werden, wobei man zu einer Struktur gemäß FIG.3 gelangt.

In der folgenden Tabelle sind Materialdaten für geeignete Schmelzmassen zusammengestellt. Neben der einzelnen oder kombinierten Verwendung dieser Schmelzmassen oder auch anderen niedrig schmelzenden Metall-Legierungen sind jedoch auch beliebige andere Materialien möglich, die die weiter oben erläuterten Bedingungen hinsichtlich eines geeigneten Phasenübergangs, der Wärmeausdehnung und der Abstimmung auf das jeweilige Halbleitermaterial erfüllen, welches nicht notwendigerweise Silizium ist. Der Füllungsgrad der Kanäle wird auf die jeweiligen Parameter angepaßt.

| -Material | Schmelzpunkt C | Schmelzwärme kcal/gmol |
|---|---|---|
| -Gallium | 29,78 | 1,335 |
| Indium | 156,6 | 0,775 |
| Zinn | 231,9 | 1,69 |
| Zinn-Blei-Cadmium-Wismut-Legierungen | 70 – 150 | |

Gleich ob in die Bauelementchips integrierte, mit Schmelzmaterial gefüllte Kanäle oder die zusätzlichen Wärmechips verwendet werden, wird auch unabhängig vom verwendeten Phasenumwandlungsmaterial der folgende anhand Fig.4 verdeutlichte Effekt erzielt. Dort ist für verschieden hohe Wärmeleistungsimpulse Q an der Chipoberfläche der jeweils zugehörige Temperaturverlauf skizziert. Die Wärmeleistung bewirkt aufgrund wärmekapazitiver Effekte an der Chipoberfläche die skizzierten an Vorder- und Rückflanke zeitlich verzögerten Temperaturanstiege und -abfälle. Die durch den ersten Wärmeimpuls hervorgerufene maximale Temperatur liegt noch deutlich unter der Umwandlungstemperatur TM des verwendeten Füllmaterials der Kanäle, während die durch den zweiten Wärmeimpuls hervorgerufene Spitzentemperatur an die Umwandlungstemperatur heranreicht. Beim dritten Impuls wird die Umwandlungstemperatur überschritten und die Wärmespitze abgeschnitten, indem die oberhalb TM, der Umwandlungstemperatur bzw. Schmelztemperatur, auftretende Wärmeleistung durch die Phasenumwandlung absorbiert wird. Die absorbierte Wärmemenge wird anschließend in der Abklingphase des Temperaturverlaufs zeitlich verzögert wieder abgegeben, bevor ein neuer Wärmeimpuls auftritt. Mit anderen Worten werden die sonst unvermeidlicherweise entstehenden kurzzeitigen Wärmespitzen durch eine Verlagerung der Aufnahme und Ableitung der zugehörigen Wärmemengen in die zeitliche Phase, in der die Chipoberflächentemperatur bereits im Abklingen begriffen ist, zuverlässig vermieden. Dies macht die besondere Wirksamkeit der erfindungsgemäßen Einrichtung für den Abbau von kritischen Wärmeimpulsen deutlich.

Die erfindungsgemäße Wärmeableitungseinrichtung ist für alle möglichen Chipanordnungen geeignet. So werden auf engstem Raum Schaltungen, Sensoren oder auch optoelektronische Komponenten auf sogenannnten Motherboards auf miteinander verdrahtet. Bei derartigen komprimierten Chipsystemen stellt die erfindungsgemäße Wärmeableitung eine erhebliche Verbesserung dar, bei der die Substratanordnung nicht verändert werden muß.

**Patentansprüche**

1. Wärmeableitungseinrichtung für elektronische Bauelemente aus Silizium und anderen Halbleitermaterialien mit im Bereich der Rückseite des Halbleiterchips zur Wärmeabfuhr vorgesehenen Kanälen, dadurch gekennzeichnet,

daß in diesen Kanälen (13) ein oder mehrere Materialien (14) in Form von Schmelzmassen aufgenommen sind, die bei Überschreiten von für die Halbleiterfunktion kritischen Temperaturen einer Wärme absorbierenden Phasenumwandlung von fest nach flüssig unterliegen.

2. Wärmeableitungseinrichtung nach Anspruch 1,
dadurch gekennzeichnet,
daß die mit Schmelzmassen gefüllten Kanäle (13) entweder in einem weiteren, möglichst dünnen Wärmeableit-Halbleiterchip (12) vorgesehen sind, der zwischen der Unterseite des Bauelement-Halbleiterchips (1) und dem Chipsockel (4) angeordnet ist, oder in den unteren Bereich des Bauelement-Halbleiterchips (1) integriert sind.

3. Wärmeableitungseinrichtung nach einem der vorhergehenden Ansprüche,
dadurch gekennzeichnet,
daß Schmelzmassen (14) einen Schmelzpunkt im Bereich von 100 C bis 150 C aufweisen, eine große Schmelzwärme haben, eine nicht sehr große Expansion zwischen dem festen und flüssigen Zustand zeigen und mit den Materialien und Techniken des Siliziums und vergleichbaren Halbleitermaterialien kompatibel sind.

4. Wärmeableitungseinrichtung nach Anspruch 1, 2 oder 3,
dadurch gekennzeichnet,
daß die Schmelzmassen aus Zinn, Indium, anderen niedrig schmelzenden Metall-Legierungen oder auch Wachsen oder Stearin oder Kombinationen hiervon bestehen.

5. Wärmeableitungseinrichtung nach einem der Ansprüche 2 bis 4,
dadurch gekennzeichnet,
daß der Wärmeableitchip (12) größer als der Bauelementchip (1) ist.

6. Verfahren zum Herstellen einer Wärmeableitungseinrichtung nach einem der vorhergehenden Ansprüche, in dem die Kanäle vorzugsweise mittels einer mikromechanischen Ätztechnik in der Oberfläche eines Halbleiterwafers ausgebildet werden,
dadurch gekennzeichnet,
daß die Kanäle teilweise mit den Schmelzmassen gefüllt werden, indem sie mittels einer geheizten Spin-Coatingapparatur auf die Oberfläche des Halbleiterwafers aufgebracht und in die Kanäle eingebracht werden, bevor der Wafer in einzelne Chips zerteilt wird.

7. Verfahren nach Anspruch 6,
dadurch gekennzeichnet,
daß die Kanäle auf der Unterseite des Wafers ausgebildet werden, die hierfür zuvor poliert wird, und daß die einzelnen Chips des Wafers als Bauelementchips verwendet werden, in die die gefüllten Kanäle integriert sind und die auf den jeweiligen Chipsockeln befestigt werden.

8. Verfahren nach Anspruch 6,
dadurch gekennzeichnet,
daß die Kanäle in die polierte Ober- oder Unterseite eines zusätzlichen Halbleiterwafers eingebracht werden und daß die einzelnen Chips mit gefüllten Kanälen aus diesem Wafer auf IC Sockel aufgelötet, geklebt oder gebondet werden und mit ihrer Oberseite durch Kleben, Löten oder anodisches Bonden mit der Unterseite eines jeweils kleineren Bauelementchips verbunden werden.

Fig.1

Fig.2

Fig.3

Fig.4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X,A | CH-A-5 464 80   (BBC)<br>* Spalte 1, Zeile 60 - Spalte 2, Zeile 3; Ansprüche 4,7 *<br>— — — | 1,2-4 | H 01 L 23/427 |
| A | DE-A-2 003 393   (THERMO-BAUELEMENT)<br>* Spalte 5, Absatz 1; Ansprüche 1,10,11 *<br>— — — | 1,3 | |
| A | DE-B-1 106 423   (LICENTIA)<br>* Spalte 3, Zeile 34 - Zeile 41; Ansprüche 1,4 *<br>— — — | 1,4 | |
| A | US-A-3 215 194   (ASTRO-DYNAMICS)<br>* Spalte 2, Zeile 15 - Zeile 20; Ansprüche 1,3 *<br>— — — | 1,4 | |
| A | EP-A-0 264 892   (FUJITSU)<br>* Ansprüche 1,2 *<br>— — — | 1,4 | |
| A | RESEARCH DISCLOSURE. Nr. 288, April 1988, NEW YORK, US Seite 228; C.M. OSBURN ET AL.: 'Structure and process for a silicon wafer chip carrier '<br>— — — — — | | |

| | |
|---|---|
| | **RECHERCHIERTE SACHGEBIETE (Int. Cl.5)**<br><br>H 01 L |

Der vorliegende Recherchenbericht wurde für alle Patentansprüche erstellt

| Recherchenort | Abschlußdatum der Recherche | Prüfer |
|---|---|---|
| Den Haag | 24 Juli 91 | ADMINISTRATION |